# DEMANDE DE BREVET EUROPEEN

(11) **EP 3 926 692 A1**
(43) Date de publication de la demande: **22.12.2021**
(21) Numéro de dépôt: 21176437.8
(22) Date de dépôt: 27.11.2019
(51) Int. Cl.: H01L 31/0224, H01L 31/05, H01L 31/0747, H01L 31/068, H01L 31/18

(54) **CELLULE ET GUIRLANDE PHOTOVOLTAIQUES ET PROCEDES DE FABRICATION ASSOCIES**

(30) Priorité: 27.11.2018 FR 1871915
(62) Demande divisionnaire de: 19812768.0
(71) Demandeur: Commissariat à l'Energie Atomique et aux Energies Alternatives, 75015 Paris (FR)
(72) Inventeur: BETTINELLI, Armand, 38054 GRENOBLE CEDEX 09 (FR)
(74) Mandataire: Cabinet Camus Lebkiri

(57) **Abrégé**

Un aspect de l'invention concerne une cellule photovoltaïque (1) comportant :
- N doigts de collecte (12) ;
- une pluralité de plots de métallisation (13-1, 13-2, 13-3) alignés sur des paires de doigts de collecte adjacents ;
- des lignes (15, 17) de rétention de l'adhésif (16) présentant des premières (15-1, 17-1) et des deuxièmes portions (15-2, 17-2) ;
les lignes (15, 17) de rétention formant avec les plots de métallisation (13-1, 13-2, 13-3), au niveau de chaque paire de doigts de collecte (12), un premier contour fermé et un deuxième contour fermé, le premier et le deuxième contour ayant chacun une arête formée par un plot de métallisation (13-1, 13-2) reliée à un doigt de collecte (12) de la paire de doigts de collecte (12).

## Description

### DOMAINE TECHNIQUE

La présente invention est relative à une cellule photovoltaïque, à une guirlande photovoltaïque comportant plusieurs cellules photovoltaïques et à leurs procédés de fabrication.

### ÉTAT DE LA TECHNIQUE

Un module photovoltaïque comprend une multitude de cellules photovoltaïques identiques connectées en série et/ou en parallèle afin de fournir en sortie la tension et/ou le courant requis pour alimenter des dispositifs électriques. Le format de module le plus courant emploie 60 cellules carrées (ou « pseudo-carrées »), de 156 mm de côté, réparties en six « chaînes » (« strings » en anglais) de dix cellules connectées en série. Les six chaînes de cellules photovoltaïques sont également connectées en série. La tension de circuit ouvert aux bornes du module est alors égale à 60 fois la tension de seuil d'une cellule photovoltaïque. Par exemple, avec des cellules photovoltaïques à homojonction en silicium présentant une tension de seuil de l'ordre de 0,65 V, la tension de circuit ouvert aux bornes du module atteint 39 V environ.

Compte tenu que toutes les cellules photovoltaïques de ce module sont connectées en série, le courant électrique du module correspond approximativement au courant fourni par chaque cellule photovoltaïque (en pratique, les cellules photovoltaïques n'ont pas exactement les mêmes performances et le courant électrique est limité par la cellule la moins performante du module). Avec les dernières technologies de cellules photovoltaïques, notamment la technologie PERT (pour « Passivated Emitter and Rear Totally diffused » en anglais), le courant d'une cellule monofaciale de 156 x 156 mm2 en superficie atteint des valeurs élevées, de l'ordre de 9 A pour une irradiance solaire de 1000 W/m2. Ces valeurs de courant sont augmentées d'environ 20 % lorsqu'on utilise une cellule bifaciale, du fait du rayonnement solaire diffus capté en face arrière de la cellule.

Les porteurs de charge photogénérés, qui contribuent au courant électrique de la cellule photovoltaïque, sont collectés grâce à un réseau d'électrodes déposé sur la face avant de la cellule. Ces électrodes, appelées également doigts de collecte, sont étroites (<100 µm). Elles sont généralement formées par sérigraphie d'une pâte contenant de l'argent. La face arrière de la cellule est soit recouverte d'un autre réseau d'électrodes (cas des cellules bifaciales), soit d'une couche métallique pleine, par exemple en aluminium (cas des cellules monofaciales). Le courant électrique circule ensuite d'une cellule à l'autre de la chaîne par des interconnexions.

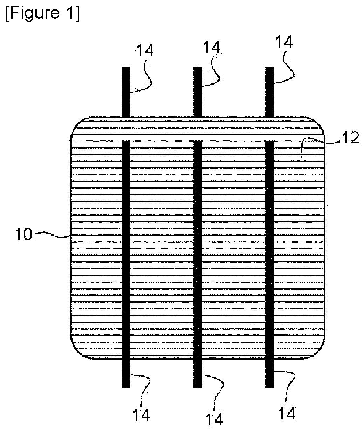

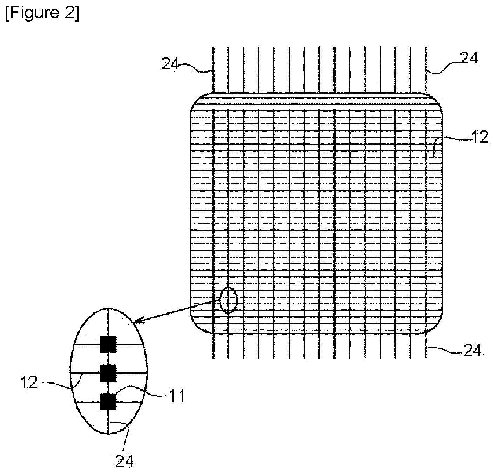

On distingue aujourd'hui deux techniques majeures pour interconnecter les cellules photovoltaïques d'une chaîne : les interconnexions en forme de ruban et les interconnexions en forme de fil électrique. Ces deux techniques sont représentées par les figures 1 et 2 respectivement.

Sur la figure 1, les interconnexions entre les cellules 10 sont constituées de rubans 14 en cuivre recouverts d'un alliage fusible, typiquement un alliage d'étain et de plomb ou un alliage d'étain et d'argent. Ces rubans 14 de section rectangulaire sont soudés sur des pistes conductrices appelées « busbars » et généralement formées en même temps que les doigts de collecte 12 par sérigraphie. Les busbars relient électriquement les doigts de collecte 12 et sont orientés perpendiculairement aux doigts de collecte 12.

Une cellule de 156 mm x 156 mm compte généralement quatre rubans de 1,2 mm de large, cinq rubans de 1,0 mm de large ou six rubans de 0,8 mm de large, ces rubans ayant une épaisseur de l'ordre de 0,2 mm. Chaque ruban 14 connecte la face avant d'une cellule 10 à la face arrière de la cellule suivante dans la chaîne (non représentée sur la figure 1). La mise en série des cellules photovoltaïques 10 au moyen des rubans 14 s'effectue de façon entièrement automatisée, dans un équipement appelé « stringer ».

Plusieurs équipementiers proposent dorénavant de remplacer les rubans de cuivre par des fils électriques de plus faible section. Par exemple, la technologie « Multi-Busbar » développée par la société « Schmid » et décrite dans l'article [« Multi-busbar solar cells and modules: high efficiencies and low silver consumption », S. Braun et al., Energy Procedia, vol. 38, pp. 334-339, 2013] multiplie le nombre de busbars déposés sur la cellule, passant de trois à quinze busbars, et soude à chaque busbar un fil de 200 µm de diamètre. Cette technologie est schématisée sur la figure 2. Les fils 24 sont constitués de cuivre et recouverts d'une fine couche d'un alliage à base d'étain-plomb ou d'étain-argent dont le point de fusion est situé au-dessus de 170 °C. Les busbars ont une forme discontinue. Ils se composent de plots de métallisation 11, d'environ 500 µm x 700 µm, alignés sur les doigts de collecte 12. Les plots de métallisation 11 et les doigts de collecte 12 sont généralement réalisés par sérigraphie d'une pâte d'argent. La soudure des fils 24 sur les plots 11 a lieu immédiatement après avoir posé les fils sur les plots, dans le même équipement, en chauffant ces éléments à une température de l'ordre de 200 °C. Ainsi, l'alliage recouvrant les fils de cuivre est fondu.

Dans le cas des rubans comme dans celui des fils, l'interconnexion des cellules photovoltaïques sur silicium est généralement réalisée par soudure desdits rubans ou fils sur les busbars. Cette technologie est choisie pour son bas coût, sa forte cadence et sa fiabilité dans le cas des cellules à homojonction. En effet, les métallisations cuites à haute température, au-delà de 700° C, sont denses et leur adhésion élevée du fait d'une liaison formée par la poudre de verre contenue dans la pâte d'argent. Il y a simplement une contrainte sur la surface des busbars, qui doit être suffisamment importante pour permettre une adhésion correcte des interconnexions car la soudure ne s'effectue que sur les zones métallisées. Par ailleurs, le marché évolue actuellement vers un plus grand nombre de busbars afin de diminuer la résistance série des doigts de collecte, en réduisant leur longueur. Avec six busbars plutôt que quatre, les rubans font généralement 0,8 mm de large afin de conserver le même ombrage qu'avec quatre rubans de 1,2 mm. On optimise alors la métallisation pour conserver une adhésion correcte des rubans ou fils sur ces surfaces plus faibles.

La problématique est différente dans le cas des cellules à hétérojonction. Elles contiennent en effet des couches amorphes qui ne peuvent être portées à des températures très supérieures à 200°C sous peine de recristalliser et anéantir les performances de la cellule. Les métallisations des cellules à hétérojonction sont à base de poudre d'argent et de résine, la résine assurant l'adhésion. La résine est généralement à base d'époxy ou d'un autre matériau capable de réticuler lors d'un traitement thermique de quelques minutes ou dizaines de minutes aux alentours de 200°C. Contrairement à la liaison inorganique des métallisations cuites à haute température des cellules à homojonction, la liaison organique des métallisations des métallisations des cellules à hétérojonction peut ne pas être inerte lors de la soudure, qui est de plus généralement réalisée en présence de flux. En conséquence, la soudure de rubans sur les busbars des cellules à hétérojonction est un procédé délicat qui ne permet généralement pas d'obtenir des interconnexions fiables, c'est-à-dire capables de résister aux contraintes liées aux dilatations différentielles des divers composants lors des variations de températures des modules photovoltaïques en fonctionnement, le cuivre se dilatant par exemple beaucoup plus que le silicium.

Des interconnexions fiables sur les cellules à hétérojonction peuvent être réalisées au moyen d'adhésifs électriquement conducteurs ECA (de l'anglais « Electrical Conductive Adhesive »). Il s'agit généralement de matériau organique à base d'époxy, d'acrylate ou d'un autre matériau capable de réticuler lors d'un traitement thermique de quelques secondes ou minutes dans la gamme de 150 à 220°C. Ce matériau organique est chargé d'un matériau ayant des propriétés conductrices, comme des poudres métalliques ou des charges métallisées en surface. Des charges à base de cuivre seraient peu coûteuses mais ce matériau n'est pas assez stable pour assurer une interconnexion fiable. Le nickel pourrait être un candidat mais le matériau donnant les meilleures performances est l'argent. Les adhésifs électriquement conducteurs ECA sont assez voisins des encres conductrices utilisées pour la métallisation des cellules à hétérojonction mais avec des matériaux et proportions optimisés de façon différente :
- priorité à la résistivité pour les encres conductrices qui doivent pouvoir conduire sur des distances de plusieurs mm, avec une aptitude à sérigraphier des lignes très étroites, de 50 µm typiquement ;
- priorité à l'adhésion et à une réticulation rapide compatible avec les stringers pour les adhésifs électriquement conducteurs ECA, avec moins de contraintes sur l'aspect sérigraphie car les motifs sont supérieurs à 100 µm. Sur l'aspect résistivité, la conduction a seulement lieu sur de faibles épaisseurs, très inférieures au mm mais le taux de charge en matériau conducteur doit rester assez élevé pour réaliser une interconnexion peu résistive, surtout si la métallisation de la cellule est de faible surface. De ce fait, le coût des adhésifs électriquement conducteurs ECA est élevé.

### RÉSUMÉ DE L'INVENTION

Il existe donc un besoin d'interconnecter les cellules photovoltaïques, notamment à hétérojonction, d'un module photovoltaïque, en limitant à la fois la quantité d'adhésif électriquement conducteur ECA des interconnexions et la quantité de pâte d'argent des métallisations, et tout en assurant une interconnexion fiable.

Un objectif de l'invention est de répondre à ce besoin.

Selon un premier aspect de l'invention, on tend à satisfaire ce besoin en prévoyant une cellule photovoltaïque comportant, sur un substrat :
- N électrodes parallèles entre elles et appelées « doigts de collecte », les doigts de collecte étant destinés à être reliés électriquement par une pluralité d'éléments d'interconnexion orientés perpendiculairement aux doigts de collecte ;
- une pluralité de plots de métallisation alignés sur M doigts de collecte, M inférieur ou égal à N et formant, perpendiculairement aux doigts de collecte, une pluralité de pistes conductrices discontinues appelées « busbar », la pluralité d'éléments d'interconnexion étant destinée à être fixée aux busbars au moyen d'un adhésif électriquement conducteur ;
- des première et deuxième lignes de rétention de l'adhésif, de part et d'autre de chaque plot de métallisation, chacune des première et deuxième lignes présentant des premières portions et des deuxièmes portions reliées au niveau des M doigts de collecte et formant entre elles un angle dans l'intervalle [30° ; 180°].

La cellule photovoltaïque selon le premier aspect de l'invention est remarquable en ce que les première et deuxième portions forment avec la pluralité de plots de métallisation, au niveau de chaque doigt de collecte parmi les M doigts de collecte, un premier contour fermé et un deuxième contour fermé, le premier contour entourant une première zone du substrat et le deuxième contour entourant une deuxième zone du substrat, le premier et le deuxième contour ayant une arête commune formée par un plot de métallisation reliée à au moins un doigt de collecte, les premier et deuxième contours au niveau du doigt de collecte parmi les M doigts de collecte n'étant pas directement en contact avec les premier et deuxième contours au niveau des autres doigts de collecte parmi les M doigts de collecte.

La cellule photovoltaïque selon le premier aspect de l'invention comporte des busbars discontinus, formés chacun d'une pluralité de plots de métallisation, ce qui permet par rapport aux busbars continus de diminuer la quantité de matière des métallisations.

Par ailleurs, les première et deuxième lignes, de part et d'autre de chaque plot de métallisation de la cellule photovoltaïque, permettent de retenir et localiser entre elles l'adhésif électriquement conducteur qui est ultérieurement utilisé, lors de l'interconnexion de plusieurs cellules photovoltaïques, pour fixer la pluralité d'éléments d'interconnexion aux busbars.

Les première et deuxième lignes associées aux busbars discontinus permettent de diminuer la quantité d'adhésif tout en assurant une bonne fiabilité de l'interconnexion. En effet, les lignes limitent le fluage de l'adhésif et permettent de mieux contrôler son épaisseur, ce qui assure une surface de contact maximale entre l'adhésif et chaque élément d'interconnexion et une meilleure pression de chaque élément d'interconnexion sur l'adhésif, donc finalement un contact électrique de meilleure qualité. Dans le même temps, les busbars discontinus permettent une adhésion mixte de l'adhésif, à la fois sur les plots de métallisation et sur le substrat, ce qui améliore la qualité de l'adhésion.

La cellule photovoltaïque selon le premier aspect de l'invention peut également présenter une ou plusieurs des caractéristiques ci-dessous, considérées individuellement ou selon toutes les combinaisons techniquement possibles :

Selon un mode de réalisation, chaque plot de métallisation présente une largeur supérieure à quatre fois la largeur d'un doigt de collecte.

Selon un mode de réalisation, chaque plot de métallisation est un micro-plot qui présente une largeur comprise entre 1,5 et 4 fois la largeur d'un doigt de collecte.

Selon un mode de réalisation, la cellule photovoltaïque comporte un unique plot de métallisation à l'intersection de chaque doigt de collecte et busbar parmi les M doigts de collecte et busbar.

Selon un mode de réalisation, la cellule photovoltaïque comporte au moins des premier, deuxième et troisième plots de métallisation à l'intersection de chaque doigt de collecte et busbar parmi les M doigts de collecte, le troisième plot de métallisation étant localisé entre les premier et deuxième plots de métallisation.

Selon un mode de réalisation, chacune des première et deuxième lignes de rétention est discontinue et comporte des tronçons localisés dans le prolongement des M doigts de collecte.

Selon un mode de réalisation, les première et deuxième lignes sont rectilignes et orientées perpendiculairement aux doigts de collecte, de part et d'autre de chaque plot de métallisation, et la cellule photovoltaïque comporte une troisième ligne de rétention de l'adhésif, orientée perpendiculairement aux doigts de collecte.

Selon un mode de réalisation, la troisième ligne de rétention est discontinue et comporte des tronçons connectant des deuxièmes contours avec des premiers contours adjacents.

Selon un mode de réalisation, la cellule photovoltaïque est une cellule à base de silicium cristallin de type hétérojonction et le substrat comporte une couche en oxyde transparent conducteur.

Selon un mode de réalisation, la cellule photovoltaïque est une cellule à base de silicium cristallin de type homojonction et le substrat comporte une couche isolante.

Un deuxième aspect de l'invention concerne une cellule photovoltaïque comportant sur un substrat :
- N électrodes parallèles entre elles et appelées « doigts de collecte », les doigts de collecte étant destinés à être reliés électriquement par une pluralité d'éléments d'interconnexion orientés perpendiculairement aux doigts de collecte ;
- un premier, deuxième et troisième plots de métallisation alignés sur chaque paire de doigts de collecte parmi P paires distinctes de doigts de collecte où P est inférieur ou égal à N/2, chaque paire de doigts de collecte étant constituée de deux doigts de collecte adjacents selon la direction perpendiculaire aux doigts de collecte, formant une pluralité de M doigts de collecte parmi les N doigts de collecte où M est égal à 2 P, le troisième plot de métallisation étant localisé entre les premier et deuxième plots de métallisation, la pluralité de premiers, deuxièmes et troisième plots de métallisation ainsi disposée formant perpendiculairement aux doigts de collecte, une pluralité de pistes conductrices discontinues appelées « busbar », la pluralité d'éléments d'interconnexion étant destinée à être fixée aux busbars au moyen d'un adhésif électriquement conducteur ;
- des première et deuxième lignes de rétention de l'adhésif, de part et d'autre de chaque plot de métallisation, chacune des première et deuxième lignes présentant des premières portions et des deuxièmes portions reliées au niveau des P paires de doigts de collecte et formant entre elles un angle dans l'intervalle [30° ; 180°] ;
où les première et deuxième portions forment avec les premier, deuxième et troisième plots de métallisation, au niveau de chaque paire de doigts de collecte parmi les P paires de doigts de collecte, un premier contour fermé et un deuxième contour fermé, le premier contour entourant une première zone du substrat et le deuxième contour entourant une deuxième zone du substrat, le premier et le deuxième contour ayant une arête commune formée par le troisième plot de métallisation et ayant chacun une arête formée par un plot de métallisation reliée à un doigt de collecte de la paire de doigts de collecte, les premier et deuxième contours au niveau de la paire de doigts de collecte parmi les P paires de doigts de collecte n'étant pas directement en contact avec les premier et deuxième contours au niveau des autres paires de doigts de collecte parmi les P paires de doigts de collecte.

Un troisième aspect de l'invention concerne une guirlande photovoltaïque comportant des première et deuxième cellules photovoltaïques selon les premier ou deuxième aspects de l'invention, interconnectées par une pluralité d'éléments d'interconnexion orientés perpendiculairement aux doigts de collecte, la pluralité d'éléments d'interconnexion reliant électriquement des doigts de collecte des première et deuxième cellules photovoltaïques ; et la pluralité d'éléments d'interconnexion étant fixée aux busbars au moyen de l'adhésif, au moins une partie de l'adhésif étant localisée perpendiculairement aux doigts de collecte entre les première et deuxième lignes et adhérant à la fois sur les plots de métallisation et sur le substrat entre les plots de métallisation.

La guirlande photovoltaïque selon le troisième aspect de l'invention peut également présenter une ou plusieurs des caractéristiques ci-dessous, considérées individuellement ou selon toutes les combinaisons techniquement possibles :

Selon un mode de réalisation, pour chaque élément d'interconnexion, l'adhésif forme une bande continue perpendiculairement aux doigts de collecte.

Selon un mode de réalisation, pour chaque élément d'interconnexion, l'adhésif forme une bande discontinue perpendiculairement aux doigts de collecte, comportant des tronçons localisés dans le prolongement des M doigts de collecte.

Selon un mode de réalisation, le rapport de la longueur de chaque tronçon, mesurée perpendiculairement aux doigts de collecte, sur l'espacement entre deux tronçons consécutifs est compris entre 1 pour 9 et 2 pour 1 et de préférence entre 1 pour 3 et 1 pour 1.

Selon un mode de réalisation, chaque élément d'interconnexion est un ruban de section rectangulaire ou pseudo rectangulaire.

Selon un mode de réalisation, chaque élément d'interconnexion est un fil de section circulaire ou pseudo circulaire.

Un quatrième aspect de l'invention concerne un procédé de fabrication d'une cellule photovoltaïque selon le premier aspect de l'invention, comportant les étapes suivantes :
- sur un substrat, réaliser N électrodes parallèles entre elles et appelées « doigts de collecte », les doigts de collecte étant destinés à être reliés électriquement par une pluralité d'éléments d'interconnexion orientés perpendiculairement aux doigts de collecte ;
- réaliser une pluralité de plots de métallisation alignés sur M doigts de collecte, M inférieur ou égal à N et formant, perpendiculairement aux doigts de collecte, une pluralité de pistes conductrices discontinues appelées « busbar », la pluralité d'éléments d'interconnexion étant destinée à être fixée aux busbars au moyen d'un adhésif électriquement conducteur ;
- réaliser des première et deuxième lignes de rétention de l'adhésif, de part et d'autre de chaque plot de métallisation, chacune des première et deuxième lignes présentant des premières portions et des deuxièmes portions reliées au niveau des M doigts de collecte et formant entre elles un angle dans l'intervalle [30° ; 180°] ;
où les première et deuxième portions forment avec la pluralité de plots de métallisation, au niveau de chaque doigt de collecte parmi les M doigts de collecte, un premier contour fermé et un deuxième contour fermé, le premier contour entourant une première zone du substrat et le deuxième contour entourant une deuxième zone du substrat, le premier et le deuxième contour ayant une arête commune formée par un plot de métallisation reliée à au moins un doigt de collecte, les premier et deuxième contours au niveau du doigt de collecte parmi les M doigts de collecte n'étant pas directement en contact avec les premier et deuxième contours au niveau des autres doigt de collecte parmi les M doigts de collecte.

Un cinquième aspect de l'invention concerne un procédé de fabrication d'une cellule photovoltaïque selon le premier aspect de l'invention, comportant les étapes suivantes :
- sur un substrat, réaliser N électrodes parallèles entre elles et appelées « doigts de collecte », les doigts de collecte étant destinés à être reliés électriquement par une pluralité d'éléments d'interconnexion orientés perpendiculairement aux doigts de collecte ;
- réaliser un premier, deuxième et troisième plots de métallisation alignés sur chaque paire de doigts de collecte parmi P paires distinctes de doigts de collecte où P est inférieur ou égal à N/2, chaque paire de doigts de collecte étant constituée de deux doigts de collecte adjacents selon la direction perpendiculaire aux doigts de collecte, formant une pluralité de M doigts de collecte parmi les N doigts de collecte où M est égal à 2 P, le troisième plot de métallisation étant localisé entre les premier et deuxième plots de métallisation, la pluralité de premiers, deuxièmes et troisième plots de métallisation ainsi disposée formant perpendiculairement aux doigts de collecte, une pluralité de pistes conductrices discontinues appelées « busbar », la pluralité d'éléments d'interconnexion étant destinée à être fixée aux busbars au moyen d'un adhésif électriquement conducteur ;
- réaliser des première et deuxième lignes de rétention de l'adhésif, de part et d'autre de chaque plot de métallisation, chacune des première et deuxième lignes présentant des premières portions et des deuxièmes portions reliées au niveau des P paires de doigts de collecte et formant entre elles un angle dans l'intervalle [30° ; 180°] ;
où les première et deuxième portions forment avec les premier, deuxième et troisième plots de métallisation, au niveau de chaque paire de doigts de collecte parmi les M paires de doigts de collecte, un premier contour fermé et un deuxième contour fermé, le premier contour entourant une première zone du substrat et le deuxième contour entourant une deuxième zone du substrat, le premier et le deuxième contour ayant une arête commune formée par le troisième plots de métallisation et ayant chacun une arête formée par un plot de métallisation reliée à un doigt de collecte de la paire de doigts de collecte, les premier et deuxième contours au niveau de la paire de doigts de collecte parmi les P paires de doigts de collecte n'étant pas directement en contact avec les premier et deuxième contours au niveau des autres paires de doigts de collecte parmi les P paires de doigts de collecte.

Un sixième aspect de l'invention concerne un procédé de fabrication d'une guirlande photovoltaïque selon le troisième aspect de l'invention, comportant les étapes suivantes :
- fabrication de première et deuxième cellules photovoltaïques selon quatrième et cinquième aspect de l'invention ;
- interconnexion des première et deuxième cellules photovoltaïques par une pluralité d'éléments d'interconnexion orientés perpendiculairement aux doigts de collecte, la pluralité d'éléments d'interconnexion reliant électriquement des doigts de collecte des première et deuxième cellules photovoltaïques ; et la pluralité d'éléments d'interconnexion étant fixée aux busbars au moyen de l'adhésif, au moins une partie de l'adhésif étant localisée perpendiculairement aux doigts de collecte entre les première et deuxième lignes et adhérant à la fois sur les plots de métallisation et sur le substrat entre les plots de métallisation.

Le procédé de fabrication d'une guirlande photovoltaïque selon le sixième aspect de l'invention peut également présenter une ou plusieurs des caractéristiques ci-dessous, considérées individuellement ou selon toutes les combinaisons techniquement possibles :

Selon un mode de réalisation, l'étape d'interconnexion comporte les sous-étapes suivantes :
- dépôt à l'intersection de chaque M doigts de collecte et busbar, au moins sur une partie du ou des plots de métallisation et du substrat autour dudit ou desdits plots de métallisation, d'une épaisseur d'adhésif supérieure à l'épaisseur des première et deuxième lignes et à l'épaisseur dudit ou desdits plots de métallisation ;
- dépôt de la pluralité d'éléments d'interconnexion sur l'adhésif précédemment déposé, en appuyant sur l'adhésif de manière à l'étaler.

Selon un mode de réalisation, l'étape d'interconnexion comporte les sous-étapes suivantes :
- dépôt à l'intersection de chaque M doigts de collecte et busbar, au moins sur une partie du ou des plots de métallisation et du substrat autour dudit ou desdits plots de métallisation, d'un volume d'adhésif supérieur au volume de largeur définie entre les première et deuxième lignes, de longueur définie par le ou les plots de métallisation et d'épaisseur définie par celle des première et deuxième lignes et/ou par celle du ou des plots de métallisation.

### BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
- Les figures 1 et 2 montrent schématiquement deux techniques d'interconnexion de cellules photovoltaïques selon l'art antérieur.
- La figure 3 montre schématiquement une vue partielle d'une cellule photovoltaïque selon un premier mode de réalisation de l'invention, comportant un unique plot de métallisation d'un premier type à l'intersection de chaque doigt de collecte et busbar.
- La figure 4 montre schématiquement une vue partielle d'une cellule photovoltaïque selon un deuxième mode de réalisation de l'invention, comportant un unique plot de métallisation d'un second type à l'intersection de chaque doigt de collecte et busbar.
- La figure 5 montre schématiquement une vue partielle d'une cellule photovoltaïque selon une variante du deuxième mode de réalisation de l'invention.
- La figure 6 montre schématiquement une vue partielle d'une cellule photovoltaïque selon un troisième mode de réalisation de l'invention, comportant deux plots de métallisation du second type à l'intersection de chaque doigt de collecte et busbar.
- La figure 7 montre schématiquement une vue partielle d'une cellule photovoltaïque selon un quatrième mode de réalisation de l'invention, comportant trois plots de métallisation du second type à l'intersection de chaque doigt de collecte et busbar.
- La figure 8 montre schématiquement une vue partielle d'une cellule photovoltaïque selon une variante du quatrième mode de réalisation de l'invention.
- La figure 9 montre schématiquement une vue partielle d'une cellule photovoltaïque selon un cinquième mode de réalisation de l'invention, comportant une troisième ligne continue de rétention de l'adhésif.
- La figure 10 montre schématiquement une vue partielle d'une cellule photovoltaïque selon un sixième mode de réalisation de l'invention, comportant une troisième ligne discontinue de rétention de l'adhésif.
- La figure 11 montre schématiquement une vue partielle d'une cellule photovoltaïque selon une variante du sixième mode de réalisation de l'invention.
- La figure 12 montre schématiquement une vue partielle d'une cellule photovoltaïque selon un septième mode de réalisation de l'invention, comportant des première et deuxième lignes discontinues de rétention de l'adhésif.
- La figure 13a montre schématiquement une vue partielle d'une cellule photovoltaïque selon un huitième mode de réalisation de l'invention, comportant des première, deuxième et troisième lignes discontinues de rétention de l'adhésif.
- La figure 13b montre schématiquement une vue partielle d'une cellule photovoltaïque selon un neuvième mode de réalisation de l'invention, comportant un motif fermé polygonal à l'intersection de chaque doigt de collecte et busbar.
- La figure 13c montre schématiquement une vue partielle d'une cellule photovoltaïque selon un dixième mode de réalisation de l'invention, comportant des première et deuxième lignes discontinues de rétention de l'adhésif, ayant chacune des première et deuxième portions reliées au niveau d'une extrémité de chaque plot de métallisation et formant entre elle un angle dans l'intervalle [30° ; 180°].
- Les figures 14, 15 et 16 montrent schématiquement trois vues partielles en face arrière de cellules photovoltaïques selon un mode de réalisation de l'invention.
- Les figures 17a et 17b montrent schématiquement deux vues partielles, de dessus et en coupe, d'une cellule photovoltaïque selon un mode de réalisation de l'invention, à l'issue d'une étape de dépôt d'adhésif pour interconnecter plusieurs cellules photovoltaïques entre elles.
- Les figures 18a et 18b montrent schématiquement deux vues partielles, de dessus et en coupe, de la cellule photovoltaïque des figures 17a et 17b, à l'issue d'une étape de dépôt d'un élément d'interconnexion sur l'adhésif précédemment déposé.
- Les figures 19a et 19b montrent schématiquement deux vues partielles de cellules photovoltaïques selon deux modes de réalisation comprenant notamment deux modes de réalisation des tronçons de l'adhésif.
- Les figures 20a et 20b montrent schématiquement deux vues partielles de cellules photovoltaïques selon un mode de réalisation comprenant trois plots de métallisation, des premières, deuxièmes et troisièmes lignes de rétention discontinues et deux modes de réalisation des tronçons de l'adhésif.
- La figure 21 montre schématiquement une vue partielle de cellule photovoltaïque selon un mode de réalisation comprenant trois plots de métallisation et des premières et deuxièmes lignes de rétention discontinues et deux modes de réalisation des tronçons de l'adhésif.
- La figure 22a et 22b montrent schématiquement deux vues partielles de cellules photovoltaïques selon un mode de réalisation comprenant un plot de métallisation, des premières et deuxièmes lignes de rétention et deux modes de réalisation des tronçons de l'adhésif.
- La figure 23 montre schématiquement une vue partielle de cellule photovoltaïque selon un mode de réalisation comprenant trois plots de métallisation, des premières, deuxièmes et troisièmes lignes de rétention discontinues et deux modes de réalisation des tronçons de l'adhésif.
- La figure 24 montre schématiquement une vue partielle de cellules photovoltaïques selon un mode de réalisation comprenant trois plots de métallisation, des premières, deuxièmes et troisièmes lignes de rétention discontinues et un autre mode de réalisation des tronçons de l'adhésif.

Pour plus de clarté, les éléments identiques ou similaires sont repérés par des signes de référence identiques sur l'ensemble des figures.

### DESCRIPTION DÉTAILLÉE

### Cellule photovoltaïque

D'une manière commune à tous les modes de réalisation détaillés ci-après, une cellule photovoltaïque 1 selon un aspect de l'invention peut être à base de silicium cristallin de type hétérojonction, ou à base de silicium cristallin de type homojonction. Une cellule photovoltaïque de type hétérojonction présente un substrat qui comporte une couche légèrement conductrice en oxyde transparent conducteur, par exemple de l'oxyde d'indium-étain ITO. Une cellule photovoltaïque de type homojonction présente un substrat qui comporte une couche isolante, par exemple en nitrure de silicium SiN.

La cellule photovoltaïque 1 comporte des métallisations, généralement formées par sérigraphie en une seule et même étape, agencées sur cette couche isolante ou légèrement conductrice : il s'agit des doigts de collecte 12, des busbars et des première et deuxième lignes 15, 17.

Les doigts de collecte 12 sont une pluralité N d'électrodes parallèles entre elles. Les busbars sont des pistes conductrices discontinues orientées perpendiculairement aux doigts de collecte 12. Chaque busbar est formé d'une pluralité de plots de métallisation 11, 13, 13-1, 13-2, 13-3 alignés sur M doigts de collecte 12, M inférieur ou égal à N. Les doigts de collecte 12 sont destinés à être reliés électriquement par une pluralité d'éléments d'interconnexion 14, 24 orientés perpendiculairement aux doigts de collecte 12, la pluralité d'éléments d'interconnexion 14, 24 étant destinée à être fixée aux busbars au moyen d'un adhésif 16 électriquement conducteur. Plusieurs cellules photovoltaïques ainsi interconnectées forment une guirlande photovoltaïque. La pluralité d'éléments d'interconnexion 14, 24 et l'adhésif 16 ne font pas partie de la cellule photovoltaïque 1 en elle-même ; ils servent à l'interconnecter avec d'autres cellules photovoltaïques.

Enfin, les première et deuxième lignes 15, 17 sont des lignes de rétention de l'adhésif 16, agencées de part et d'autre de chaque plot de métallisation 11, 13, 13-1, 13-2, 13-3.

### Cellule photovoltaïque - Doigts de collecte

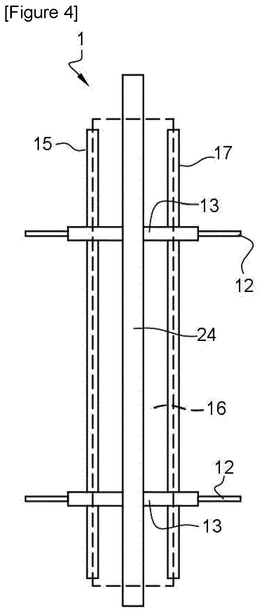

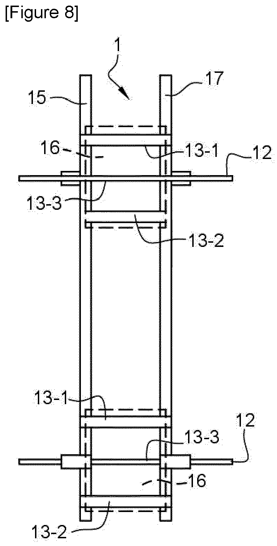

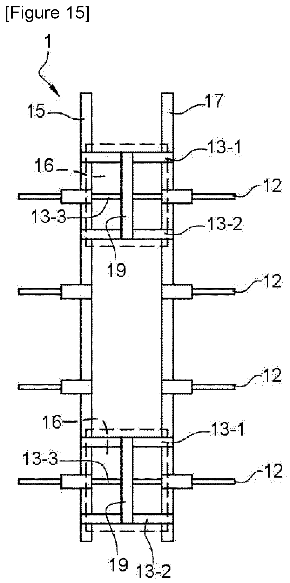

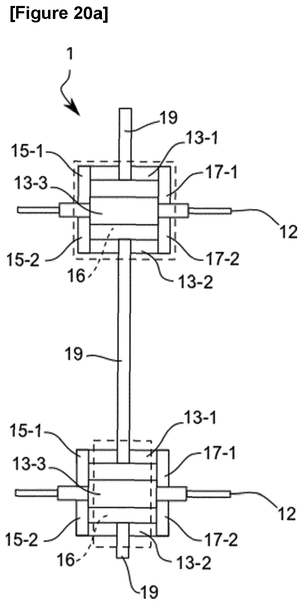

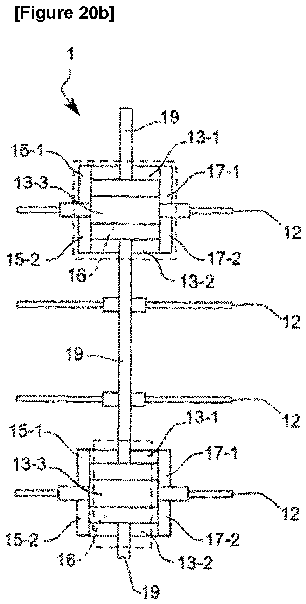

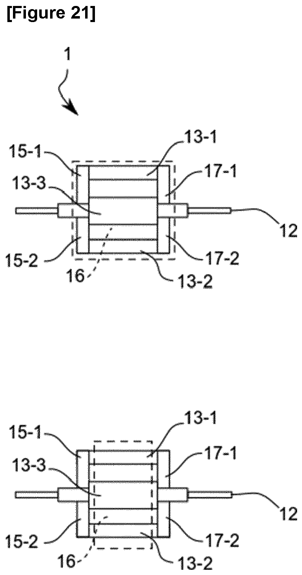

Chaque doigt de collecte 12 présente avantageusement une partie élargie dans chaque zone de contactage, au niveau de sa jonction avec une ligne de rétention, ainsi qu'illustré aux figures 4 à 17b, 19a à 24, ce qui permet de disposer d'une surface de contact suffisante. La qualité de contact électrique de l'adhésif électriquement conducteur est en effet nettement meilleure avec la pâte d'argent des doigts de collecte 12 qu'avec le substrat, par exemple en ITO dans le cas d'une cellule à hétérojonction.

### Cellule photovoltaïque - Busbars et plots de métallisation

La cellule photovoltaïque 1 peut comporter un unique plot de métallisation 11, 13 à l'intersection de chaque doigt de collecte 12 et busbar.

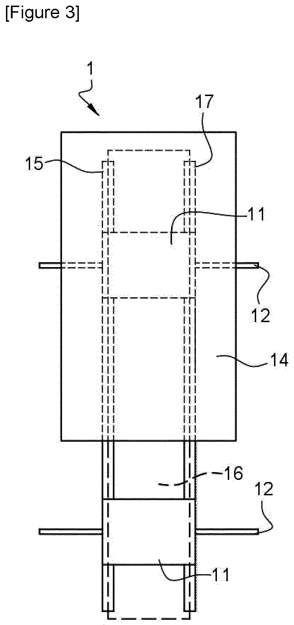

Cet unique plot de métallisation peut être d'un premier type 11, tel qu'illustré à la figure 3, et présenter une largeur, mesurée perpendiculairement aux doigts de collecte 12, supérieure à quatre fois celle des doigts de collecte 12. Plus précisément, le plot du premier type 11 peut présenter :
- une largeur dans l'intervalle [200 µm ; 600 µm], typiquement une largeur de l'ordre 300 µm ; et
- une longueur, mesurée parallèlement aux doigts de collecte 12, avantageusement supérieure à 350 µm et de préférence de l'ordre de 600 µm.

Alternativement, cet unique plot de métallisation peut être d'un second type 13, tel qu'illustré aux figures 4, 6, 9, 13c, 22a et 22b, et présenter une largeur, mesurée perpendiculairement aux doigts de collecte 12, supérieure à 1,5 fois celle des doigts de collecte 12. Plus précisément, le plot du second type 13 peut présenter :
- une largeur dans l'intervalle [80 µm ; 200 µm], typiquement une largeur de l'ordre de 100 µm, par exemple égale à 120 µm ; et
- une longueur, mesurée parallèlement aux doigts de collecte 12, avantageusement supérieure à 350 µm et de préférence de l'ordre de 500 µm.

Dans la suite du présent document, on fera indifféremment référence à un « plot du second type » ou à un « micro-plot ».

Dans le cas particulier où les éléments d'interconnexion sont des fils 24, moins contraignants mécaniquement que des rubans 14, les doigts de collecte 12 peuvent présenter une largeur de l'ordre de 30 µm et le micro-plot 13 une largeur dans l'intervalle [50 µm ; 200 µm], avantageusement dans l'intervalle [50 µm ; 80 µm].

La dimension des plots du premier comme du second type, parallèlement aux doigts de collecte 12, est ainsi nettement inférieure à celle d'un busbar standard et d'un ruban d'interconnexion standard, soit 1,2 mm dans une configuration à quatre busbars. Non seulement les busbars sont discontinus - formés chacun d'une pluralité de plots de métallisation, mais chaque busbar est en outre beaucoup plus étroit (dans la direction parallèle aux doigts de collecte 12) qu'un busbar standard, ce qui permet d'utiliser beaucoup moins de pâte d'argent. Cela est possible sans perdre en adhérence car, contrairement à la technique de soudure où le mouillage donc l'adhésion ne se fait que sur les zones métallisées, l'adhésif conducteur adhère non seulement sur les plots de métallisation mais également sur le substrat entre les plots de métallisation. Dans le cas d'adhésifs conducteurs de type epoxy et acrylique, on observe même une tenue mécanique 2 à 3 fois supérieure sur le substrat non métallisé (par exemple en ITO ou SiN/SiO₂) que sur les métallisations.

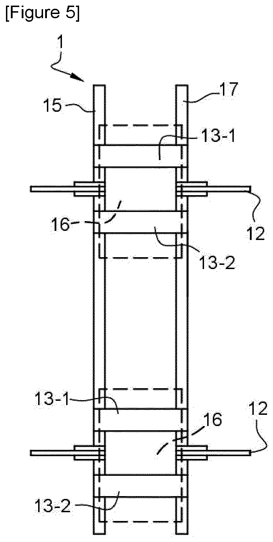

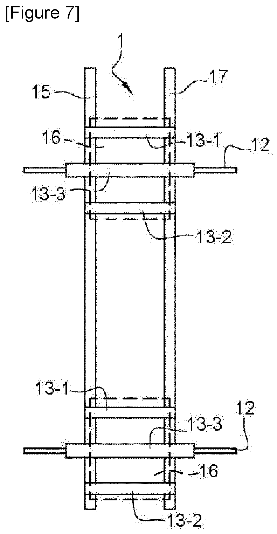

La cellule photovoltaïque 1 peut alternativement comporter une pluralité de micro-plots de métallisation 13-1, 13-2, 13-3 à l'intersection d'une partie des doigts de collecte ou à l'intersection de chaque doigt de collecte 12 et busbar, et notamment des premier et deuxième micro-plots de métallisation 13-1, 13-2 ainsi qu'illustré aux figures 5, 10, 13b, 17a et 17b, ou bien des premier, deuxième et troisième micro-plots de métallisation 13-1, 13-2, 13-3, dont le troisième plot de métallisation 13-3 est localisé entre les premier et deuxième plots de métallisation 13-1, 13-2, ainsi qu'illustré aux figures 7, 8, 11 à 13a, 14 à 16, 19a et 19b, 20a et 20b, 21, 23 et 24. Dans cette alternative, la pluralité de micro-plots contribue avec les lignes de rétention à localiser l'adhésif 16 qui est utilisé ultérieurement lors de l'interconnexion de plusieurs cellules photovoltaïques 1 au sein d'une guirlande photovoltaïque. On contrôle alors le fluage de l'adhésif 16 dans deux directions du plan, grâce aux lignes de rétention perpendiculaires aux doigts de collecte 12 et aux micro-plots de métallisation 13-1, 13-2, 13-3 parallèles aux doigts de collecte 12. Par rapport à une configuration avec un unique plot 11 du premier type, la configuration à deux ou trois micro-plots 13-1, 13-2, 13-3 permet de réduire la quantité d'adhésif 16 requise. Par ailleurs, la configuration à trois micro-plots 13-1, 13-2, 13-3 permet d'augmenter la surface de contact de l'adhésif 16 sur les surfaces métallisées et de garantir que le troisième micro-plot 13-3, central, sera bien recouvert d'adhésif 16 y compris en cas de léger désalignement lors du dépôt de l'adhésif 16.

Le troisième plot de métallisation 13-3, centrale au motif de rétention de l'adhésif 16, doit être suffisamment large pour que le contact électrique et mécanique soit optimal. Ainsi, comme précisé plus haut, sa largeur, mesurée perpendiculairement aux doigts de collecte 12, doit être comprise dans un intervalle [80 µm ; 200 µm] et de préférence égale à 120 µm. Le rôle des première et deuxième lignes de rétention 15, 17 et des premier et deuxième plots de métallisation 13-1, 13-2 est de localiser l'adhésif 16. Ainsi, dans un mode de réalisation, les largeurs des première et deuxième ligne de rétention 15, 17, mesurées parallèlement aux doigts de collecte 12, et les largeurs des premier et deuxième plots de métallisation 13-1, 13-2, mesurées perpendiculairement aux doigts de collecte 12, sont inférieures, de préférence strictement inférieures, à la largeur du troisième plot de métallisation 13-3. Dans un mode de réalisation, l'adhésif 16 s'étend sur la surface de la cellule photovoltaïque 1 sous forme de bandes, retenu par les première et deuxième lignes de rétention 15, 17, parallèlement aux éléments d'interconnexion 14, 24. Ainsi, les premier et deuxième plots de métallisation 13-1, 13-2 sont recouverts d'adhésif 16 et participent au contact électrique et mécanique. De préférence les largeurs des premier et deuxième plots de métallisation sont choisies de sorte à être supérieures, voire strictement supérieures, aux largeurs des première et deuxième lignes de rétention 15, 17.

Il est intéressant d'augmenter le nombre de busbars de la cellule photovoltaïque 1, c'est-à-dire le nombre de zones d'interconnexion, afin de réduire la longueur des doigts de collecte 12 entre deux interconnexions successives. La diminution des pertes résistives dans les doigts de collecte permet d'augmenter les performances de la cellule photovoltaïque 1 grâce à un meilleur facteur de forme. Cela offre également la possibilité d'augmenter le courant en réduisant la largeur des doigts de collecte 12. En réduisant significativement la surface métallisée dans chaque zone d'interconnexion, la présente invention permet de diminuer la consommation de pâte d'argent dans chaque zone d'interconnexions et donc d'augmenter le nombre d'interconnexions sans gros impact sur la consommation de pâte d'argent.

### Cellule photovoltaïque - Lignes de rétention

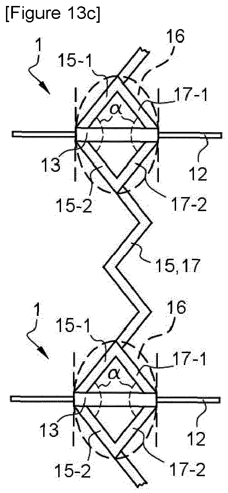

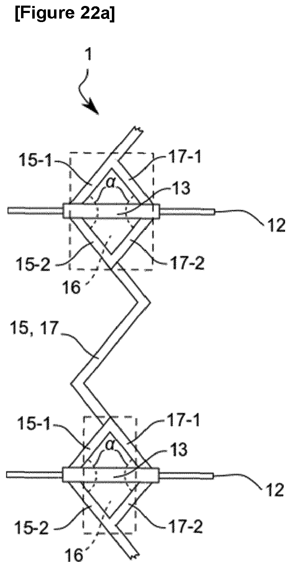

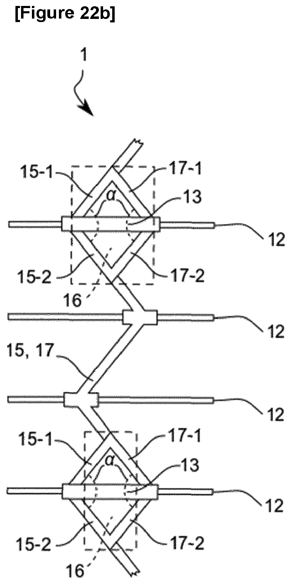

Chacune des première et deuxième lignes 15, 17 présente au moins des première 15-1, 17-1 et deuxième 15-2, 17-2 portions reliées au niveau d'un doigt de collecte 12 et formant entre elles un angle α dans l'intervalle [30° ; 180°]. L'angle α peut être égal à 180°, c'est-à-dire être plat : dans ce cas les première et deuxième lignes 15, 17 sont rectilignes et orientées perpendiculairement aux doigts de collecte 12, ainsi qu'illustré aux figures 3 à 12, 13a et 13b, 14 à 16, 17a, 17b, 19a à 21, 23 à 24. Lorsque l'angle α n'est pas plat, ainsi qu'illustré aux figures 13c, 22a et 22b, il est par exemple égal à 136° ou à 90° ou à 80°. Cette configuration où l'angle α n'est pas plat est avantageuse dans le cas de l'utilisation d'écrans dits « zéro degré » ou « knotless ». Lorsque l'angle α vaut 136°, chacune des première et deuxième portions forme de préférence un même angle de 68° par rapport aux doigts de collecte 12, ou autrement dit de 22° par rapport à la perpendiculaire aux doigts de collecte 12. Ce cas particulier est illustré schématiquement aux figures 13c, 22a et 22b. De même, lorsque l'angle α vaut 90°, chacune des première et deuxième portions forme de préférence un même angle de 45° par rapport aux doigts de collecte 12 ; lorsque l'angle α vaut 80°, chacune des première et deuxième portions forme de préférence un même angle de 40° par rapport aux doigts de collecte 12, ou autrement dit de 50° par rapport à la perpendiculaire aux doigts de collecte 12 ; et lorsque l'angle α vaut 30°, chacune des première et deuxième portions forme de préférence un même angle de 15° par rapport aux doigts de collecte 12, ou autrement dit de 75° par rapport à la perpendiculaire aux doigts de collecte 12. Ce dernier cas où l'angle α vaut 30° peut en particulier être avantageux pour une interconnexion par fils 24. Par ailleurs, l'angle α est préférentiellement défini, pour chacune des première et deuxième lignes 15, 17, de manière que les première et deuxième lignes 15, 17 puissent se rejoindre et former un motif fermé convexe, c'est-à-dire tout entier du même côté de la droite supportant l'un quelconque de ses côtés, au niveau de l'intersection entre chaque doigt de collecte 12 et busbar.

Les premières portions 15-1, 17-1 et deuxièmes portions 15-2, 17-2 des première et deuxième lignes de rétention 15, 17 sont matérialisables aux points de connexion des première et deuxième lignes de rétention 15, 17 avec des premier, deuxième et troisième plots de métallisation 13-1, 13-2, 13-3 comme illustré sur les figures 7, 8, 10 à 12, 13a, 14 à 16, 19a et 19b, 20a et 20b, 21, 23 et 24. La cellule photovoltaïque 1 peut comporter uniquement des première et deuxième lignes 15, 17, ainsi qu'illustré aux figures 3 à 8, 13b, 13c et 14, 19a et 19b, 21, 22a et 22b.

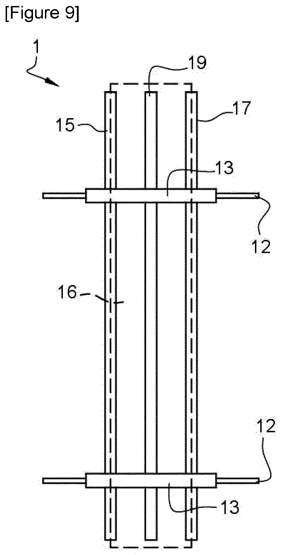

Alternativement, lorsque les première et deuxième lignes 15, 17 sont rectilignes et orientées perpendiculairement aux doigts de collecte 12, la cellule photovoltaïque 1 peut en outre comporter une troisième ligne 19 orientée perpendiculairement aux doigts de collecte 12, entre les première et deuxième lignes 15, 17, ainsi qu'illustré aux figures 9 à 13a, 15 et 16, 20a et 20b, 23 et 24. Dans cette alternative, le surplus de pâte d'argent requis par la troisième ligne 19 est compensé par une diminution de la quantité d'adhésif 16 ultérieurement utilisé. Cette configuration permet de garantir que la troisième ligne 19, centrale, soit ultérieurement recouverte d'adhésif 16, y compris en cas de léger désalignement lors du dépôt de l'adhésif 16.

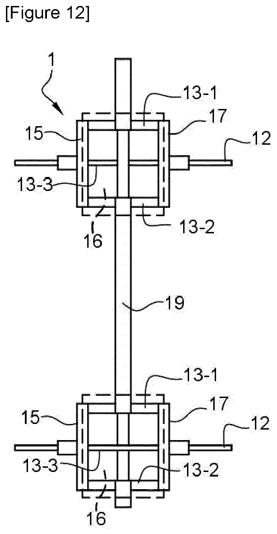

Les première et deuxième lignes 15, 17 peuvent être continues, ainsi qu'illustré aux figures 3 à 11, 13c et 14, 19a et 19b, de manière à relier les doigts de collecte 12 entre eux, dans une direction perpendiculaire aux doigts de collecte 12. Alternativement, les première et deuxième lignes 15, 17 peuvent être discontinues, ainsi qu'illustré aux figures 12, 13a et 13b, 20a et 20b, 21, 23 et 24. Dans ce cas, elles comportent des tronçons localisés dans le prolongement des doigts de collecte 12, sans que les doigts de collecte 12 soient nécessairement reliés entre eux, dans une direction perpendiculaire aux doigts de collecte 12, par les différents tronçons. Lorsque les première et deuxième lignes 15, 17 sont discontinues, elles sont entièrement distinctes l'une de l'autre. Lorsque les première et deuxième lignes 15, 17 sont continues, elles peuvent être entièrement distinctes l'une de l'autre ou être partiellement confondues, ainsi qu'illustré aux figures 13c, 22a et 22b où les première et deuxième lignes 15, 17 sont distinctes l'une de l'autre au niveau des motifs, et confondues l'une avec l'autre entre les motifs.

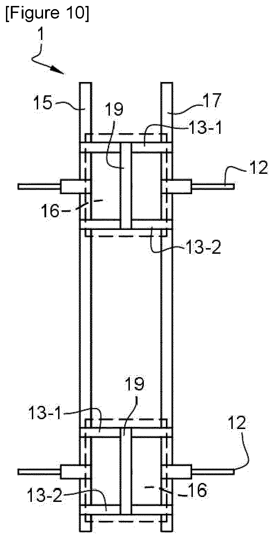

De même, la troisième ligne 19 peut être continue, ainsi qu'illustré aux figures 9, 12 et 16, ou discontinue, ainsi qu'illustré aux figures 10, 11, 13a et 15, 20a et 20b, 23 et 24. Au moins une troisième ligne 19 discontinue comportant des tronçons connectant les contours d'un doigt de collecte parmi les M doigts de collecte aux contours de doigts de collecte adjacents parmi les M doigts de collecte, permet de réaliser une connexion électrique entre tous les motifs (ou contours comme cela sera détaillé dans la suite). Ainsi, il n'est pas nécessaire de recourir à un testeur I(V) particulier pour réaliser la caractérisation électrique de la cellule photovoltaïque 1.

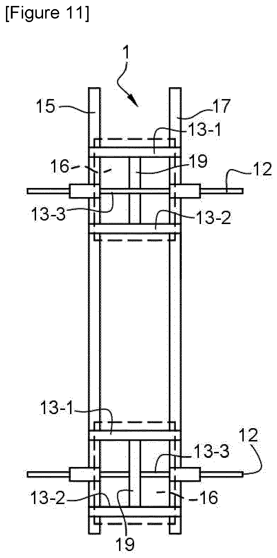

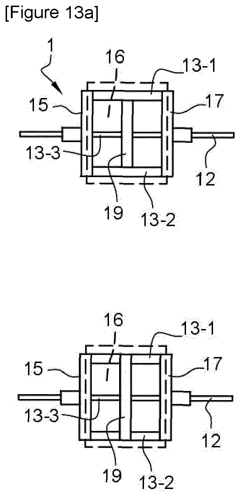

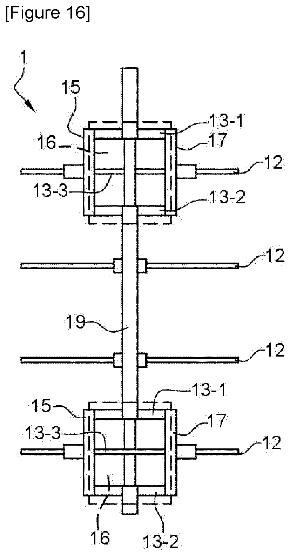

Lorsque la cellule photovoltaïque 1 comporte des première, deuxième et troisième lignes 15, 17, 19, à la fois les première, deuxième et troisième lignes 15, 17, 19 peuvent être continues ainsi qu'illustré à la figure 9, ou bien seulement les première et deuxième lignes 15, 17 ainsi qu'illustré aux figures 10, 11, ou bien seulement la troisième ligne 19 ainsi qu'illustré aux figures 12 et 16, ou bien aucune (c'est-à-dire que toutes les lignes sont discontinues) ainsi qu'illustré à la figure 13a. Dans ce dernier cas de figure où toutes les lignes sont discontinues, il n'y a donc pas de liaison entre les différentes zones d'un busbar. On utilisera alors ultérieurement un testeur I(V) disposant d'une unité de contactage spécifique, capable de contacter ces zones non reliées.

Chaque ligne présente avantageusement une largeur légèrement supérieure à celle desdits conducteurs de collecte. Un conducteur ou doigt de collecte est typiquement de largeur comprise dans l'intervalle [40 µm ; 60 µm]. Par exemple, une largeur de ligne de 70 µm ou 100 µm est adéquate. Cela permet de faciliter l'impression des lignes. En effet, l'impression est plus facile dans un sens, le sens de raclage, et on choisit ce sens pour les conducteurs de collecte qui sont plus étroits, donc plus difficiles à imprimer.

D'une manière générale, l'invention n'est pas limitée aux exemples particuliers illustrés sur les figures et les lignes de rétention peuvent présenter toutes les caractéristiques suivantes :
- deux lignes 15, 17, continues ou discontinues, rectilignes ou non, et combinées avec un plot ou micro-plot ou deux ou trois micro-plots ;
- ou trois lignes 15, 17, 19 rectilignes, toutes continues ou avec une troisième ligne discontinue ou toutes discontinues, et combinées avec un plot ou micro-plot ou deux ou trois micro-plots.

Les lignes de rétention combinées au plot ou micro-plot ou à la pluralité de micro-plots peuvent notamment former toute une gamme de motifs parmi lesquels :
- un carré ou un rectangle (deux lignes de rétention rectilignes, deux micro-plots) ;
- un carré ou un rectangle avec séparation « horizontale » (deux lignes de rétention rectilignes, trois micro-plots) ;
- un carré ou un rectangle avec séparation « verticale » (trois lignes de rétention rectilignes, deux micro-plots) ;
- un carré ou un rectangle avec quadrillage (trois lignes de rétention rectilignes, trois micro-plots) ;
- un losange ou un parallélogramme avec séparation « horizontale » (deux lignes de rétention angulaires, un plot ou micro-plot) ;
- un hexagone (deux lignes de rétention angulaires, deux micro-plots) ;
- un hexagone avec séparation « horizontale » (deux lignes de rétention angulaires, trois micro-plots) ; etc.

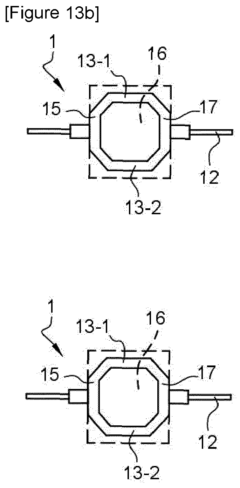

D'autres motifs peuvent naturellement être envisagés sans sortir du cadre de l'invention, par exemple un octogone tel qu'illustré à la figure 13b, où deux lignes de rétention 15, 17 rectilignes sont reliées à deux micro-plots 13-1, 13-2 de manière à former un octogone. Plus généralement, les lignes de rétention, éventuellement combinées à un ou plusieurs plots ou micro-plots, peuvent former un motif polygonal, de préférence régulier, voire circulaire.

Autrement dit, les première 15-1, 17-1 et deuxième 15-2, 17-2 portions forment avec la pluralité de plots de métallisation 11, 13, 13-1, 13-2, 13-3, au niveau de chaque doigt de collecte parmi les M doigts de collecte, un premier contour fermé et un deuxième contour fermé, lesdits contours pouvant être de forme quelconque, de forme polygonales (cf. les figures 7, 8, 11, 12, 13a, 13c, 14 à 16, 19a à 24) ou bien encore de forme ellipsoïde ou circulaire. De plus, les premier et deuxième contours comportent une arête commune, formée par un des plots de métallisation 11, 13, 13-1, 13-2, 13-3. Il peut s'agir d'un unique plot de métallisation 13 comme présenté sur les figures 13c, 22a et 22b ou d'un troisième plot de métallisation 13-3 comme présenté sur les figures 7, 8, 14, 19a et 19b, 20a et 20b, 21, 23 et 24. Par ailleurs, ces contours entourent deux zones libres du substrat, destinées notamment à recevoir une partie de l'adhésif.

Il est utile de noter que les premier et deuxième contours au niveau du doigt de collecte 12 parmi les M doigts de collecte 12 ne sont pas directement en contact avec les premier et deuxième contours au niveau des autres doigt de collecte 12 parmi les M doigts de collecte 12. Ils peuvent toutefois être indirectement en contact indirecte au moyen de première, deuxième ou troisième lignes de rétention 15, 17, 19. Deux contours sont considérés comme "directement en contact" lorsque les deux contours sont sécants ou tangents l'un de l'autre.

### Cellule photovoltaïque - Face avant, face arrière

Les figures 3 à 13c, 19a, 20a, 21 et 22a, précédemment décrites montrent préférentiellement une face avant d'une cellule photovoltaïque 1, c'est-à-dire la face qui est destinée à être exposée au rayonnement solaire incident. Le pas d'espacement des conducteurs de collecte 12 y est typiquement compris dans l'intervalle [1,0 mm ; 2.5 mm] et plus précisément [1,8 mm ; 2,1 mm] pour les cellules à hétérojonction.

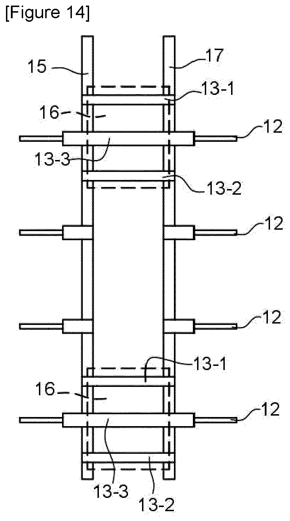

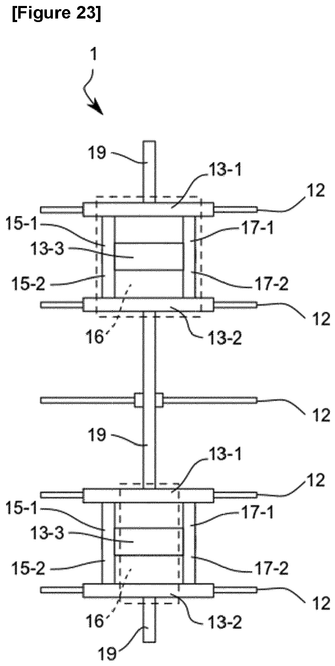

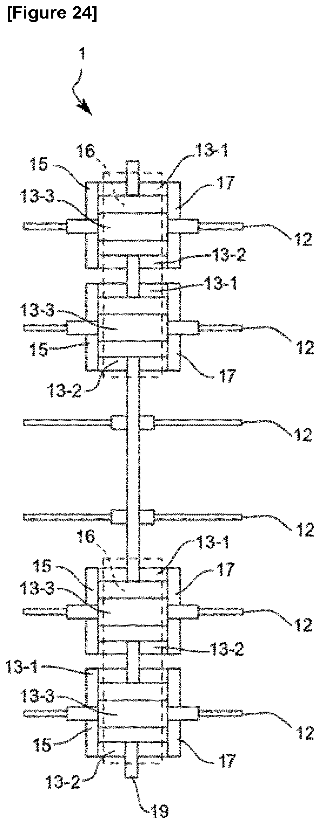

Dans le cas particulier de cellules bifaciales où les deux faces peuvent capter le rayonnement solaire, la face avant est celle permettant d'obtenir le maximum de courant électrique lorsqu'elle est tournée vers le rayonnement incident. En face arrière, l'ombrage étant moins critique, le pas des conducteurs de collecte 12 est généralement plus serré, typiquement compris dans l'intervalle [0,5 mm ; 1,5 mm] et plus précisément [0,6 mm ; 1,0 mm] pour les cellules à hétérojonction. Dans ce cas, ainsi qu'illustré aux figures 14 à 16, 19b, 20b, 22b et 24, on ne connecte préférentiellement qu'une partie des conducteurs de collecte 12 dans la direction des conducteurs de collecte 12, via les plots 11, 13, 13-1, 13-2, 13-3 et/ou les lignes 15, 17. Ce mode de réalisation, préconisé en face arrière, peut également être utilisé en face avant. Les figures 14 à 16, 19b, 20b et 22b montrent des exemples où seulement un conducteur de collecte sur trois est connecté via lesdits plots et/ou lignes. La figure 23 montre un exemple de réalisation où deux conducteurs de collecte sur trois sont connectés via lesdits plots et/ou lignes. La figure 24 montre un exemple de réalisation où deux conducteurs de collecte sur quatre sont connectés via lesdits plots et/ou lignes. De manière générale, pour une cellule comportant N conducteurs de collecte, il peut n'y avoir que M conducteurs de collecte sur les N conducteurs de collecte connectés via lesdits plots et/ou lignes avec M<N (le cas M=N correspondant au cas présenté précédemment où chaque conducteur de collecte est connecté via lesdits plots et/ou lignes). Les conducteurs de collecte 12 restent en revanche tous connectés dans la direction qui leur est perpendiculaire, par les première et deuxième lignes 15, 17 et/ou la troisième ligne 19. Les figures 14, 15, 19b et 22b montrent ainsi quatre exemples où les première et deuxième lignes 15, 17, continues, connectent tous les conducteurs de collecte 12 ; tandis que les figures 16, 20b, 23, 24 montrent des exemples où les conducteurs de collecte 12 sont tous reliés par la troisième ligne 19, continue, ainsi que les micro-plots 13-1, 13-2, 13-3 et les première et deuxième lignes 15, 17, discontinues.

### Cellule photovoltaïque - Paires de doigts de collecte

Alternativement, un autre mode de réalisation permet de réaliser des busbars discontinues perpendiculairement aux doigts de collecte 12. Pour cela une pluralité de P paires distinctes de doigts de collecte 12 est formée, chaque paire de doigts de collecte 12 étant constituée de deux doigts de collecte 12 adjacents selon la direction perpendiculaire aux doigts de collecte 12. Le nombre P de paires de doigts de collecte 12 est entier et inférieur ou égal à N/2. Les P paires de doigts de collecte 12 forment à leur tour une pluralité de M doigts de collecte 12 parmi les N doigts de collecte 12 où M est égal à 2 P.

Par exemple si une cellule photovoltaïque 1 comporte 8 doigts de collecte 12, il peut être formé au maximum 4 paires distinctes de doigts de collecte 12 distinguant 8 doigts de collecte 12. Si une cellule photovoltaïque 1 comporte 3 doigts de collecte 12, il peut alors être formé au maximum 1 paire de doigts de collecte 12 distinguant 2 doigts de collecte 12.

Un premier, deuxième et troisième plots de métallisation 13-1, 13-2, 13-3 sont alignés sur chaque paire de doigts de collecte 12 parmi les P paires distinctes de doigts de collecte 12, la pluralité de premier, deuxième et troisième plots de métallisation 13-1, 13-2, 13-3 formant ainsi les busbars destinés à être fixés aux éléments d'interconnexion 14, 24.

De manière avantageuse, pour chaque paire de doigt de collecte 12, les premier et deuxième plots de métallisation 13-1, 13-2 sont reliés à chaque doigt de collecte 12 et le troisième plot de métallisation 13-3 est localisé entre les premier et deuxième plots de métallisation 13-1, 13-3.

Des premières et deuxièmes lignes 15, 17 sont disposés de part et d'autre des plots de métallisation 13-1, 13-2, 13-3. Chaque première et deuxième lignes 15, 17 comporte, pour chaque paire de doigts de collecte 12, des premières portions 15-1, 17-1 et des deuxièmes portions 15-2, 17-2 reliées au niveau du troisième plot de métallisation 13-3 et formant ainsi un premier contour fermé et un deuxième contour fermé ayant chacun une arête commune formée par le troisième plot de métallisation 13-3. Par ailleurs, ces contours entourent deux zones libres du substrat, destinées à recevoir une partie de l'adhésif.

Les premier et deuxième contours formés au niveau d'une paire de doigts de collecte 12 parmi les P paires de doigts de collecte 12 ne sont pas directement en contact avec les premier et deuxième contours formés au niveau des autres paires de doigts de collecte 12 parmi les P paires de doigts de collecte 12. En revanche des troisièmes lignes de rétention 19 discontinues peuvent relier, par des tronçons, des deuxième contours formés au niveau d'une paire de doigt de collecte avec des premiers contours formés au niveau des paires adjacentes de doigts de collecte 12, parmi les paires adjacentes et distinctes selon la direction perpendiculaire aux doigts de collecte 12.

### Guirlande photovoltaïque

L'interconnexion de plusieurs cellules photovoltaïques 1 telles que précédemment décrites permet de former une guirlande photovoltaïque. Cette interconnexion est réalisée au moyen d'une pluralité d'éléments d'interconnexion 14, 24, fixés aux busbars des cellules photovoltaïques 1 par l'intermédiaire d'un adhésif électriquement conducteur 16.

### Guirlande photovoltaïque - Adhésif électriquement conducteur

L'adhésif électriquement conducteur 16 peut par exemple être un adhésif epoxy ou acrylique.

Par rapport à une technologie de soudure où le mouillage donc l'adhésion ne se fait que sur les surfaces métallisées, l'adhésif 16 présente l'avantage d'adhérer à la fois sur les surfaces métallisées et non métallisées. Cela permet de réduire les surfaces métallisées sans perdre en adhérence. En réduisant les surfaces métallisées et utilisant une surface d'adhésion mixte, métallisée et non métallisée, on observe même une amélioration de la qualité de l'adhésion. En effet, l'adhésif 16 adhère généralement 2 à 3 fois mieux sur le substrat non métallisé, par exemple en ITO ou SiN/SiO₂, que sur les métallisations.

L'adhésif 16 peut se présenter sous la forme d'une bande continue alignée, perpendiculairement aux doigts de collecte 12, sur chaque busbar, ainsi qu'illustré aux figures 3, 4 et 9. Cette bande continue présente avantageusement une largeur, mesurée parallèlement aux doigts de collecte 12, sensiblement identique à celle de chaque busbar précédemment décrit, donc nettement (de l'ordre de deux fois) inférieure à celle d'un ruban d'interconnexion standard (qui est de 1,2 mm). Par rapport à une soudure, on réduit significativement la surface d'adhésion mais sans risque de rupture car l'adhésif 16 est plus ductile qu'une soudure, ce qui lui permet de mieux résister aux contraintes thermiques liées aux dilatations différentielles.

Dans le cas précédemment décrit où l'on souhaite augmenter le nombre de busbars et donc de zones d'interconnexion, à consommation d'adhésif similaire pour chaque zone d'interconnexion, utiliser des bandes continues d'adhésif 16 peut se révéler pénalisant car coûteux.

Pour répondre notamment à cette problématique, on prévoit alternativement que l'adhésif 16 se présente sous la forme d'une bande discontinue alignée, perpendiculairement aux doigts de collecte 12, sur chaque busbar et comportant des tronçons localisés dans le prolongement des M doigts de collecte 12, dont les contours, ainsi qu'illustré aux figures 5 à 8 et 10 à 17b, 19a à 24. Le fait que chaque tronçon soit localisé dans le prolongement des M doigts de collecte 12 permet d'éviter les pertes résistives, en permettant aux charges électriques provenant des conducteurs de collecte 12 de passer directement dans un tronçon d'adhésif 16, via les plots de métallisation 11, 13, 13-1, 13-2, 13-3 et les lignes 15, 17, 19 en contact avec ledit tronçon d'adhésif 16. Cette localisation particulière des tronçons, associée aux motifs de métallisation particuliers formés par les plots 11, 13, 13-1, 13-2, 13-3 et lignes 15, 17, 19 précédemment décrits pour la cellule photovoltaïque, permet effectivement d'assurer une interconnexion fiable du fait de la localisation de l'adhésif et de la multiplicité des zones de métallisation en contact avec l'adhésif, dont les lignes centrales totalement recouvertes. La pluralité de tronçons formant des bandes discontinues d'adhésif 16 est préférentiellement déposée par une technologie de sérigraphie.

Les tronçons d'une même ligne discontinue sont de préférence sensiblement de même longueur, mesurée perpendiculairement aux doigts de collecte 12, et régulièrement espacés. Le rapport de la longueur de chaque tronçon sur l'espacement entre deux tronçons consécutifs est préférentiellement compris entre 1 pour 9 (c'est-à-dire que l'espacement est neuf fois plus grand que chaque tronçon) et 2 pour 1 (c'est-à-dire que chaque tronçon est deux fois plus grand que l'espacement). De manière encore plus préférentielle, le rapport de la longueur de chaque tronçon sur l'espacement entre deux tronçons consécutifs est compris entre 1 pour 3 (c'est-à-dire que l'espacement est trois fois plus grand que le tronçon) et 1 pour 1 (c'est-à-dire que l'espacement est égal à la longueur de chaque tronçon). En particulier, le rapport de la longueur de chaque tronçon sur l'espacement entre deux tronçons consécutifs peut avantageusement être de 1 pour 2 (c'est-à-dire que l'espacement est deux fois plus grand que le tronçon).

### Guirlande photovoltaïque - Elément d'interconnexion

Chaque élément d'interconnexion peut typiquement se présenter sous la forme d'un ruban 14, ainsi que partiellement représenté à la figure 3, ou d'un fil 24, ainsi que représenté à la figure 4. Le ruban 14 de la figure 3 n'est que partiellement représenté afin de faciliter la lecture de cette figure. Sur toutes les figures suivantes 5 à 16 et 19a à 24, aucun élément d'interconnexion n'est plus représenté, pour des raisons de meilleure lisibilité. Toutefois, il est entendu que toutes les cellules photovoltaïques selon les exemples de réalisation des figures 3 à 16 et 19a à 24 peuvent être interconnectées soit par des rubans 14, soit par des fils 24. Chaque élément d'interconnexion 14, 24 est fixé au busbar de chaque cellule photovoltaïque 1 qu'il interconnecte via un adhésif 16 électriquement conducteur. Les caractéristiques du busbar, formé de plots de métallisation 11, 13, 13-1, 13-2, 13-3, et de l'adhésif 16 électriquement conducteur ont été précédemment décrites. Les éléments d'interconnexion 14, 24 et leur adhésif 16 ne font pas partie des cellules photovoltaïques 1 en elles-mêmes ; ils servent à les interconnecter entre elles de manière à former une guirlande photovoltaïque.

Chaque ruban 14 d'interconnexion présente une section rectangulaire, typiquement de 1,2 mm (dans une configuration à quatre busbars), 1 mm (dans une configuration à cinq busbars) ou 0,8 mm (dans une configuration à six busbars) ou encore 0,6 mm et 0,2 mm de haut, ou pseudo-rectangulaire, par exemple en cas de structuration à la surface du ruban 14. Un ruban structuré peut par exemple présenter une structuration en dents de scie à sa surface. L'orientation des stries permet de renvoyer une partie des photons arrivant sur les rubans vers la cellule via une réflexion sur le verre, ce qui permet une augmentation du courant et donc des watts produits pour le module.

Chaque fil 24 d'interconnexion présente quant à lui une section circulaire, typiquement de 200 µm, 250 µm ou 300 µm de diamètre, ou pseudo-circulaire, par exemple ovale ou elliptique.

### Procédé de fabrication d'une cellule photovoltaïque

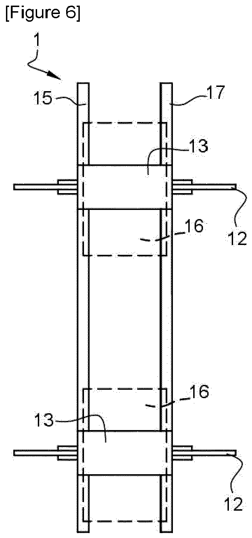

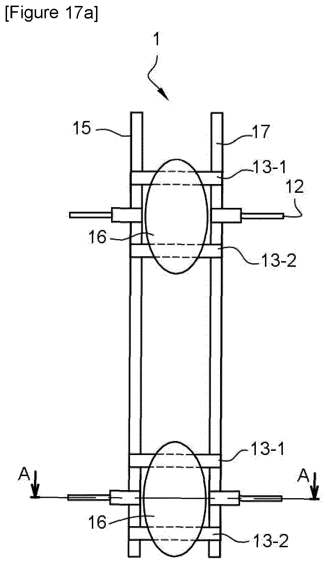

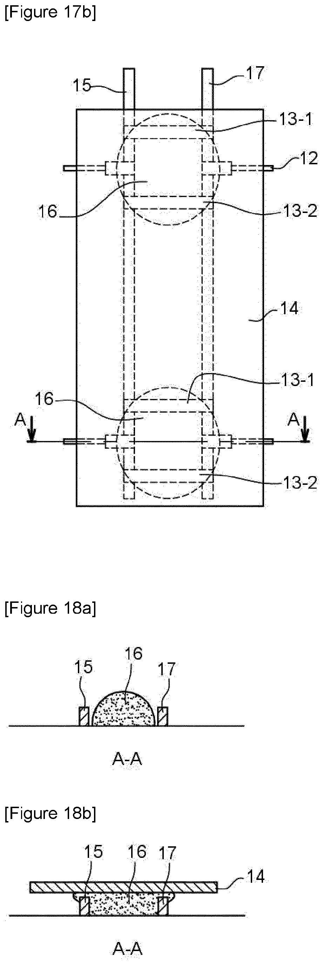

Toutes les figures 3 à 16 et 19a à 24 précédemment décrites montrent la forme et les dimensions de l'adhésif 16 après dépôt des éléments d'interconnexion 14, 24. Toutefois l'adhésif 16 est avantageusement déposé sous forme de motif plus réduit dans le plan du substrat mais plus haut hors du plan du substrat, afin d'être comprimé et étalé, dans la limite du motif de métallisation formé par les lignes 15, 17, 19 et éventuellement par les plots 13-1, 13-2, 13-3, au moment du dépôt des éléments d'interconnexion 14, 24. Les figures 17a et 17b montrent respectivement une vue de dessus et une vue en coupe (A-A) de la cellule photovoltaïque 1 de la figure 6, sur laquelle des gouttes d'adhésif 16 ont été déposées, dont la largeur (dans la direction des doigts de collecte 12) est inférieure à l'espacement entre les lignes 15, 17 et la hauteur (normale au plan du substrat) est supérieure à celle des lignes 15, 17. Les figures 18a et 18b montrent respectivement une vue de dessus et une vue en coupe (A-A) de la cellule photovoltaïque 1 de la figure 6, sur laquelle un ruban 14 est déposé, qui cause l'étalement de la goutte d'adhésif 16 et sa compression entre le ruban 14, le substrat et le motif de métallisation formé des lignes et plots.

Chaque goutte d'adhésif 16 déposée est préférentiellement de hauteur supérieure à celle des lignes 15, 17. Par ailleurs, chaque goutte d'adhésif 16 déposée a préférentiellement un volume supérieur à celui défini par le motif de métallisation, c'est-à-dire : hauteur (normalement au plan du substrat) des première et deuxième lignes 15, 17 ; largeur (parallèlement aux doigts de collecte 12) entre les première et deuxième lignes 15, 17 ; longueur (perpendiculairement aux doigts de collecte 12) du plot de métallisation 11, 13 ou entre les premier et deuxième micro-plots de métallisation 13-1, 13-2. On garantit ainsi que l'adhésif 16 remplira tout ce volume après application de l'élément d'interconnexion, et donc que le contact sera fiable. Le dépôt de l'élément d'interconnexion peut avantageusement entraîner un débordement de l'adhésif 16 hors du motif de métallisation, autorisant un léger désalignement des gouttes d'adhésif 16 lors de leur dépôt.

Par exemple, un motif dont l'espacement entre les lignes 15, 17 (mesuré dans la direction des doigts de collecte 12) de 460 µm accueillera une goutte d'adhésif 16 dont la largeur est comprise entre 300 µm et 460 µm, préférentiellement 345 µm.

Il est envisageable de déposer une goutte d'adhésif 16 plus large que le motif sérigraphié, recouvrant totalement les premières et deuxièmes lignes de rétention 15,17, comme présenté sur les motifs hauts des figures, 19a à 23, afin de permettre un plus grand désalignement des éléments d'interconnexion 14, 24. Par exemple, un motif dont la largeur externe (parallèle aux doigts de collecte 12) est de 600 µm, pourra être recouvert par une goutte d'adhésif 16 d'une largeur comprise entre 600 µm et 720 µm, préférentiellement 700 µm. De même, un motif dont la largeur externe (parallèle aux doigts de collecte 12) est de 400 µm, pourra être recouvert par une goutte d'adhésif 16 d'une largeur comprise entre 400 µm et 600 µm, préférentiellement 550 µm.

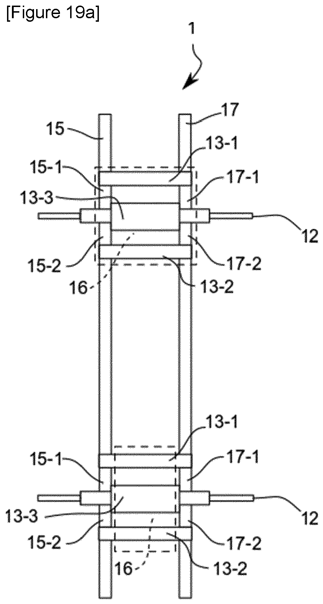

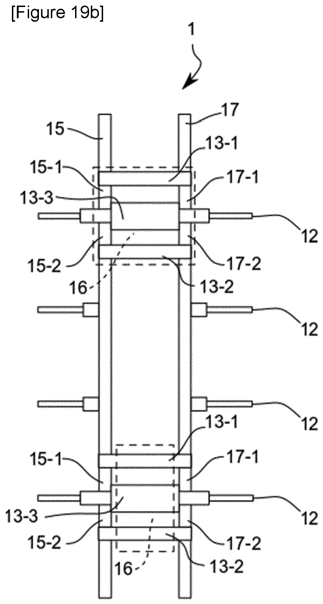

Du fait que l'étalement de la goutte d'adhésif 16 dans la direction des éléments d'interconnexion 14, 24 lors de sa compression par les éléments d'interconnexion 14, 24 ne créé pas d'ombrage, il est envisageable de déposer des gouttes d'adhésif 16 plus étroite (parallèlement aux doigts de collecte 12) et plus longue (perpendiculairement aux doigts de collecte 12) que les motifs sérigraphiés comme présenté sur les motifs bas des figures 19a à 23 et sur tous les motifs des figures 24 et 24. Par exemple, un motif dont la longueur externe (perpendiculaire aux doigts de collecte 12) est de 700 µm pourra être recouvert par une goutte d'adhésif 16 dont la longueur est comprise entre 700 µm et 1300 µm, préférentiellement 1100 µm.

Comme déjà mentionné auparavant, la qualité de l'adhésion est améliorée lorsqu'une partie de l'adhésif est localisée sur le substrat et une autre partie est localisée sur des parties métallisées. On parle dans ce cas-là d'adhésion mixte. Le rapport de la surface de substrat contactée divisée par la surface métallisée contactée pourra être compris entre 1 et 4, et de préférence entre 1.5 et 3.5.

Par exemple, un motif comportant un troisième plot de métallisation de longueur égale à 120 µm, dont les longueur et largeur extérieures sont 700 µm x 600 µm et les longueur et largeur intérieures sont 560 µm x 460 µm, pourra comporter un tronçon d'adhésif de longueur et largeur 700 µm x 460 µm. Ainsi 0.20 mm² d'adhésif est en contact avec le substrat tandis que 0.12 mm² est en contact avec les zones métallisées, soit un rapport de surface d'environ 1.69.

Le même un motif pourra comporter un tronçon d'adhésif de longueur et largeur 1100 µm x 350 µm. Ainsi 0.29 mm² d'adhésif est en contact avec le substrat tandis que 0.09 mm² est en contact avec les zones métallisées, soit un rapport de surface d'environ 3.23.

## Revendications

1. Cellule photovoltaïque (1) **caractérisée en ce qu'**elle comporte, sur un substrat :
- N électrodes (12) parallèles entre elles et appelées « doigts de collecte », les doigts de collecte (12) étant destinés à être reliés électriquement par une pluralité d'éléments d'interconnexion (14, 24) orientés perpendiculairement aux doigts de collecte (12) ;
- un premier, deuxième et troisième plots de métallisation (13-1, 13-2, 13-3) alignés sur chaque paire de doigts de collecte (12) parmi P paires distinctes de doigts de collecte (12) où P est inférieur ou égal à N/2, chaque paire de doigts de collecte (12) étant constituée de deux doigts de collecte (12) adjacents selon la direction perpendiculaire aux doigts de collecte (12), formant une pluralité de M doigts de collecte (12) parmi les N doigts de collecte (12) où M est égal à 2 P, le troisième plot de métallisation (13-3) étant localisé entre les premier et deuxième plots de métallisation (13-1, 13-2), la pluralité de premiers, deuxièmes et troisième plots de métallisation (13-1, 13-2, 13-3) ainsi disposée formant perpendiculairement aux doigts de collecte, une pluralité de pistes conductrices discontinues appelées « busbar », la pluralité d'éléments d'interconnexion (14, 24) étant destinée à être fixée aux busbars au moyen d'un adhésif (16) électriquement conducteur ;
- des première et deuxième lignes (15, 17) de rétention de l'adhésif (16), de part et d'autre de chaque plot de métallisation (13-1, 13-2, 13-3), chacune des première et deuxième lignes (15, 17) présentant des premières portions (15-1, 17-1) et des deuxièmes portions (15-2, 17-2) reliées au niveau des troisième plots de métallisation (13-3) et formant entre elles un angle dans l'intervalle [30° ; 180°] ;
et **en ce que** les première (15-1, 17-1) et deuxième (15-2, 17-2) portions forment avec les premier, deuxième et troisième plots de métallisation (13-1, 13-2, 13-3), au niveau de chaque paire de doigts de collecte (12) parmi les P paires de doigts de collecte (12), un premier contour fermé et un deuxième contour fermé, le premier contour entourant une première zone du substrat et le deuxième contour entourant une deuxième zone du substrat, le premier et le deuxième contour ayant une arête commune formée par le troisième plots de métallisation (13-3) et ayant chacun une arête formée par un plot de métallisation (13-1, 13-2, 13-3) reliée à un doigt de collecte (12) de la paire de doigts de collecte (12), les premier et deuxième contours au niveau de la paire de doigts de collecte (12) parmi les P paires de doigts de collecte (12) n'étant pas directement en contact avec les premier et deuxième contours au niveau des autres paires de doigts de collecte (12) parmi les P paires de doigts de collecte (12).

2. Cellule photovoltaïque (1) selon la revendication précédente, **caractérisée en ce que** les largeurs des première et deuxième lignes de rétention (15, 17) mesurées parallèlement aux doigts de collecte (12) sont strictement inférieures aux largeurs des premier et deuxième plots de métallisation (13-1, 13-2) mesurées perpendiculairement aux doigts de collecte (12) et **en ce que** les largeurs des premier et deuxième plots de métallisation (13-1, 13-2) mesurées perpendiculairement aux doigts de collecte (12) sont strictement inférieures à la largeur du troisième plot de métallisation (13-3) mesurée perpendiculairement aux doigts de collecte (12).

3. Cellule photovoltaïque (1) selon l'une quelconque des revendications précédentes, **caractérisée en ce que** chacune des première et deuxième lignes (15, 17) de rétention est discontinue et comporte des tronçons localisés dans le prolongement des M doigts de collecte (12).

4. Cellule photovoltaïque (1) selon l'une quelconque des revendications précédentes, **caractérisée en ce que** les première et deuxième lignes (15, 17) sont rectilignes et orientées perpendiculairement aux doigts de collecte (12), de part et d'autre de chaque plot de métallisation (11, 13, 13-1, 13-2, 13-3), et **en ce qu'**elle comporte une troisième ligne (19) de rétention de l'adhésif (16), orientée perpendiculairement aux doigts de collecte (12).

5. Cellule photovoltaïque (1) selon la revendication précédente, **caractérisée en ce que** la troisième ligne (19) de rétention est discontinue et comporte des tronçons connectant des deuxièmes contours avec des premiers contours adjacents.

6. Guirlande photovoltaïque comportant des première et deuxième cellules photovoltaïques (1) selon l'une quelconque des revendications précédentes, interconnectées par une pluralité d'éléments d'interconnexion (14, 24) orientés perpendiculairement aux doigts de collecte (12), la pluralité d'éléments d'interconnexion (14, 24) reliant électriquement les doigts de collecte (12) des première et deuxième cellules photovoltaïques (1) ; et la pluralité d'éléments d'interconnexion (14, 24) étant fixée aux busbars au moyen de l'adhésif (16), au moins une partie de l'adhésif (16) étant localisée perpendiculairement aux doigts de collecte (12) entre les première et deuxième lignes (15, 17) et adhérant à la fois sur les plots de métallisation (11, 13, 13-1, 13-2, 13-3) et sur le substrat entre les plots de métallisation (11, 13, 13-1, 13-2, 13-3).

7. Guirlande photovoltaïque selon la revendication précédente, **caractérisée en ce que** pour chaque élément d'interconnexion (14, 24), l'adhésif (16) forme une bande continue perpendiculairement aux doigts de collecte (12).

8. Guirlande photovoltaïque (1) selon la revendication 6, **caractérisée en ce que** pour chaque élément d'interconnexion (14, 24), l'adhésif (16) forme une bande discontinue perpendiculairement aux doigts de collecte (12), comportant des tronçons localisés dans le prolongement des M doigts de collecte (12).

9. Guirlande photovoltaïque (1) selon la revendication précédente, **caractérisée en ce que** le rapport de la longueur de chaque tronçon, mesurée perpendiculairement aux doigts de collecte (12), sur l'espacement entre deux tronçons consécutifs est compris entre 1 pour 9 et 2 pour 1 et de préférence entre 1 pour 3 et 1 pour 1.

10. Procédé de fabrication d'une cellule photovoltaïque (1) selon l'une quelconque des revendications 1 à 5, comportant les étapes suivantes :
- sur un substrat, réaliser N électrodes (12) parallèles entre elles et appelées « doigts de collecte », les doigts de collecte (12) étant destinés à être reliés électriquement par une pluralité d'éléments d'interconnexion (14, 24) orientés perpendiculairement aux doigts de collecte (12) ;
- réaliser un premier, deuxième et troisième plots de métallisation (13-1, 13-2, 13-3) alignés sur chaque paire de doigts de collecte (12) parmi P paires distinctes de doigts de collecte (12) où P est inférieur ou égal à N/2, chaque paire de doigts de collecte (12) étant constituée de deux doigts de collecte (12) adjacents selon la direction perpendiculaire aux doigts de collecte (12), formant une pluralité de M doigts de collecte (12) parmi les N doigts de collecte (12) où M est égal à 2 P, le troisième plot de métallisation (13-3) étant localisé entre les premier et deuxième plots de métallisation (13-1, 13-2), la pluralité de premiers, deuxièmes et troisième plots de métallisation (13-1, 13-2, 13-3) ainsi disposée formant perpendiculairement aux doigts de collecte, une pluralité de pistes conductrices discontinues appelées « busbar », la pluralité d'éléments d'interconnexion (14, 24) étant destinée à être fixée aux busbars au moyen d'un adhésif (16) électriquement conducteur ;
- réaliser des première et deuxième lignes (15, 17) de rétention de l'adhésif (16), de part et d'autre de chaque plot de métallisation (13-1, 13-2, 13-3), chacune des première et deuxième lignes (15, 17) présentant des premières portions (15-1, 17-1) et des deuxièmes portions (15-2, 17-2) reliées au niveau des troisième plots de métallisation (12-3) et formant entre elles un angle dans l'intervalle [30° ; 180°] ;
et en ce que les première (15-1, 17-1) et deuxième (15-2, 17-2) portions forment avec les premier, deuxième et troisième plots de métallisation (13-1, 13-2, 13-3), au niveau de chaque paire de doigts de collecte (12) parmi les P paires de doigts de collecte (12), un premier contour fermé et un deuxième contour fermé, le premier contour entourant une première zone du substrat et le deuxième contour entourant une deuxième zone du substrat, le premier et le deuxième contour ayant une arête commune formée par le troisième plots de métallisation (13-3) et ayant chacun une arête formée par un plot de métallisation (13-1, 13-2, 13-3) reliée à un doigt de collecte (12) de la paire de doigts de collecte (12), les premier et deuxième contours au niveau de la paire de doigts de collecte (12) parmi les P paires de doigts de collecte (12) n'étant pas directement en contact avec les premier et deuxième contours au niveau des autres paires de doigts de collecte (12) parmi les P paires de doigts de collecte (12).

11. Procédé de fabrication d'une guirlande photovoltaïque selon l'une quelconque des revendications 6 à 9, comportant les étapes suivantes :
- fabrication de première et deuxième cellules photovoltaïques (1) selon le procédé de la revendication 10 ;
- interconnexion des première et deuxième cellules photovoltaïques (1) par une pluralité d'éléments d'interconnexion (14, 24) orientés perpendiculairement aux doigts de collecte (12), la pluralité d'éléments d'interconnexion reliant électriquement les doigts de collecte (12) des première et deuxième cellules photovoltaïques (1) ; et la pluralité d'éléments d'interconnexion (14, 24) étant fixée aux busbars au moyen de l'adhésif (16), au moins une partie de l'adhésif (16) étant localisée perpendiculairement aux doigts de collecte (12) entre les première et deuxième lignes (15, 17) et adhérant à la fois sur les plots de métallisation (11, 13, 13-1, 13-2, 13-3) et sur le substrat entre les plots de métallisation (11, 13, 13-1, 13-2, 13-3).

12. Procédé de fabrication selon la revendication précédente, **caractérisé en ce que** l'étape d'interconnexion comporte les sous-étapes suivantes :
- dépôt à l'intersection de chaque doigt de collecte (12) et busbar parmi les M doigts de collecte (12)au moins sur une partie du ou des plots de métallisation (11, 13, 13-1, 13-2, 13-3) et du substrat autour dudit ou desdits plots de métallisation (11, 13, 13-1, 13-2, 13-3), d'une épaisseur d'adhésif (16) supérieure à l'épaisseur des première et deuxième lignes (15, 17) et à l'épaisseur dudit ou desdits plots de métallisation (11, 13, 13-1, 13-2, 13-3) ;
- dépôt de la pluralité d'éléments d'interconnexion (14, 24) sur l'adhésif (16) précédemment déposé, en appuyant sur l'adhésif (16) de manière à l'étaler.

13. Procédé de fabrication selon l'une quelconque des revendications 11 ou 12, **caractérisé en ce que** l'étape d'interconnexion comporte les sous-étapes suivantes :
- dépôt à l'intersection de chaque doigt de collecte (12) et busbar parmi les M doigts de collecte (12),au moins sur une partie du ou des plots de métallisation (11, 13, 13-1, 13-2, 13-3) et du substrat autour dudit ou desdits plots de métallisation (11, 13, 13-1, 13-2, 13-3), d'un volume d'adhésif (16) supérieur au volume de largeur définie entre les première et deuxième lignes (15, 17), de longueur définie par le ou les plots de métallisation (11, 13, 13-1, 13-2, 13-3) et d'épaisseur définie par celle des première et deuxième lignes (15, 17) et/ou par celle du ou des plots de métallisation (11, 13, 13-1, 13-2, 13-3).
